(19) **Europäisches Patentamt European Patent Office Office européen des brevets**

(11) **EP 4 641 233 A1**

(12) **EUROPEAN PATENT APPLICATION**
published in accordance with Art. 153(4) EPC

(43) Date of publication:
29.10.2025 Bulletin 2025/44

(21) Application number: 23906903.2

(22) Date of filing: 14.12.2023

(51) International Patent Classification (IPC):
*G01R 31/396* (2019.01)    *G01R 31/367* (2019.01)
*H02J 7/00* (2006.01)

(52) Cooperative Patent Classification (CPC):
**G01R 31/367; G01R 31/396; H02J 7/00**

(86) International application number:
**PCT/JP2023/044925**

(87) International publication number:
**WO 2024/135539 (27.06.2024 Gazette 2024/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **21.12.2022  JP 2022204203**

(71) Applicant: **Panasonic Intellectual Property Management Co., Ltd.**
**Kadoma-shi, Osaka 571-0057 (JP)**

(72) Inventor: **SADA, Tomokazu**
**Kadoma-shi, Osaka 571-0057 (JP)**

(74) Representative: **Novagraaf International SA**
**Chemin de l'Echo 3**
**1213 Onex, Geneva (CH)**

(54) **DATA ANALYSIS SYSTEM, CELL DEFECT NOTIFICATION SYSTEM, DATA ANALYSIS METHOD, AND DATA ANALYSIS PROGRAM AND RECORDING MEDIUM ON WHICH DATA ANALYSIS PROGRAM IS WRITTEN**

(57)    In a data analysis system, an analysis unit analyzes time-series data. A determination unit determines whether each of values included in the time-series data is an actual measured value or an imputed value. A preprocessing unit is capable of switching between using or not using an imputed value for data analysis when the time-series data includes the imputed value. The time-series data may be battery data including at least the voltage of a secondary battery. The preprocessing unit can delete an imputed value from the time-series data when the imputed value is not to be used for data analysis.

FIG. 1

## Description

### TECHNICAL FIELD

The present disclosure relates to a data analysis system configured to analyze battery data and the likes, a cell defect notification system, a data analysis method, and a data analysis program.

### BACKGROUND ART

An analysis system for various types of time-series data of secondary batteries sometimes executes imputation processing for a data missing section. Patent Literature 1 relates to data imputation of image data and discloses a method in which information on a target indicating a series of inputs is produced based on a temporal or spatial positional relationship between input portions having been subjected to input from the outside; when the target is temporarily lost, processing for the imputation of the lost data is performed; and, when an unstable target is produced, processing to delete the unstable target is performed. In this method, imputation calculation for the lost data is needed to determine whether to impute or delete the target, and imputed data need to be subjected to quality judgment, which causes higher data processing loads.

### RELATED ART

Citation List

Patent Literature 1: Japanese Unexamined Patent Application Publication No. 2010-238094

### SUMMARY

In time-series data of secondary batteries, the imputation of missing data contributes to increased opportunities for secondary battery diagnosis or analysis. However, there is a possibility that a diagnosis or analysis based on time-series data including an imputed value may induce a misdiagnosis, a false positive, or a false negative.

The present disclosure has been made in view of these circumstances, and an object of the present disclosure is to provide a technology to improve the precision of data analysis.

To solve the above-mentioned problem, a data analysis system according to an aspect of the present disclosure includes: an analysis unit configured to analyze time-series data; a determination unit configured to determine whether each of values included in the time-series data is an actual measured value or an imputed value; and a preprocessing unit capable of, when the imputed value is included in the time-series data, switching between using or not using the imputed value for data analysis.

Note that any combination of the above-mentioned constituents and what is obtained by converting between a device, a system, a computer program, and a recording medium in the expression of the present disclosure are also effective as aspects of the present disclosure.

According to the present disclosure, the precision of data analysis can be improved.

### BRIEF DESCRIPTION OF THE DRAWINGS

FIG. 1 is a diagram for explaining a cell defect notification system and a battery analysis system according to an embodiment.
FIG. 2 is a diagram illustrating a configuration example of a battery assembly system.
FIG. 3A is a diagram illustrating an example of changes in the voltage of a block.
FIG. 3B is a diagram illustrating an example of changes in the voltage difference between blocks.
FIG. 4 is a graph illustrating the relationship between the voltage of a normal block illustrated in Fig. 3A and the voltage difference between blocks illustrated in Fig. 3B.
FIG. 5 is a diagram summarizing setting rules for thresholds to be compared with a voltage fault level.
FIG. 6A is a graph illustrating that, when the number of parallel cells, P, in a block is 2 and the number of faulty cells, F, in the block is 1, a voltage fault level is 1.
FIG. 6B is a graph illustrating that, when the number of parallel cells, P, in a block is 2 and the number of faulty cells, F, in the block is 1, a voltage fault level is 1.
FIG. 7 is a flowchart illustrating the flow of basic processing for cell fault detection.

FIG. 8 is a flowchart for explaining a specific example of filtering in faulty cell detection processing performed by the battery analysis system according to the embodiment.

FIG. 9 is a diagram for explaining the role of a transient response filter.

FIG. 10 is a diagram illustrating time-series data of current in which a missing section illustrated in FIG. 9 is imputed by interpolation.

FIG. 11 is a diagram illustrating time-series data of current from which imputed data illustrated in FIG. 10 are deleted.

## DETAILED DESCRIPTIONS

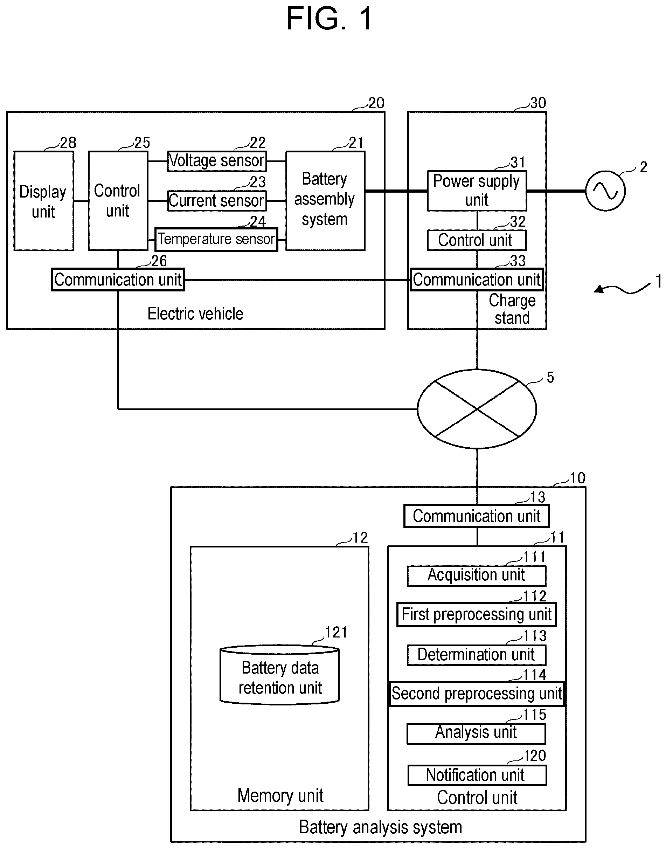

FIG. 1 is a diagram for explaining cell defect notification system 1 and battery analysis system 10 according to an embodiment. Cell defect notification system 1 according to the embodiment includes battery analysis system 10, control unit 25, communication unit 26, and display unit 28. Control unit 25, communication unit 26, and display unit 28 are installed in electric vehicle 20. Battery analysis system 10 according to the embodiment is a system configured to analyze a battery pack installed in electric vehicle 20. Battery analysis system 10 may be built, for example, on a company's own server installed in a company's own facility or a data center of a company that provides analysis services for the battery pack installed in electric vehicle 20. Alternatively, battery analysis system 10 may be built on a cloud server to be used based on cloud services. Alternatively, battery analysis system 10 may be built on a plurality of servers respectively distributed to a plurality of locations (the data center and the company's own facility). The servers may be any of a combination of a plurality of company's own servers, a combination of a plurality of cloud servers, and a combination of a company's own server and a cloud server.

Battery assembly system 21 included in the battery pack installed in electric vehicle 20 provides power to a motor for driving (not illustrated). Battery assembly system 21 includes a plurality of parallel cell blocks connected in series. To increase a battery capacity, each of the parallel cell blocks includes a plurality of cells connected in parallel.

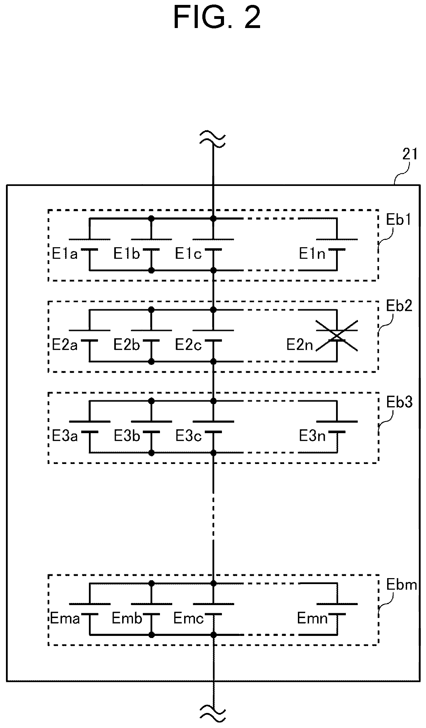

FIG. 2 is a diagram illustrating a configuration example of battery assembly system 21. Battery assembly system 21 includes parallel cell blocks (Eb1-Ebm) connected in series. The parallel cell blocks Eb1-Ebm respectively include a plurality of cells E1a-E1n to Ema-Emn connected in parallel.

Lithium ion battery cells, nickel hydride battery cells, lead battery cells, and other types of cells can be used as the cells. Hereinafter, in the present specification, an example of using lithium ion battery cells (nominal voltage: 3.6-3.7 V) is assumed. The number of the parallel cell blocks connected in series is determined, based on the voltage of a motor for driving.

Voltage sensor 22 is configured to measure voltages at both ends of each of the parallel cell blocks connected in series. A shunt resistance is connected in series to the parallel cell blocks connected in series. Current sensor 23 is configured to measure an electric current flowing through each of the parallel cell blocks connected in series, based on voltages at both ends of the shunt resistance. Note that a Hall element may be used, instead of the shunt resistance. A plurality of temperature sensors 24 is installed in the battery pack including battery assembly system 21. For example, a thermistor can be used as temperature sensor 24.

Control unit 25 is configured with a combination of a battery management unit (BMU) and an electronic control unit (ECU). The BMU estimates a state of charge (SOC) by using an open circuit voltage (OCV) method and a current integration method in combination. The OCV method is a method of estimating an SOC based on the OCV of a cell to be measured and an SOC-OCV curve of the cell. The SOC-OCV curve of the cell is produced in advance, based on a characteristic test by a battery manufacturer, and registered in the BMU at the time of shipment. Control unit 25 according to the embodiment can cause display unit 28 to display a result detected by analysis unit 115 described later.

The current integration method is a method of estimating an SOC, based on an OCV at the start of cell charge/discharge and an integrated value of measured currents. In the current integration method, current measurement errors accumulate as charge-and-discharge time becomes longer. Therefore, a weighted average of the SOC estimated by the current integration method and the SOC estimated by the OCV method is preferably used.

The BMU sends battery data including voltages, currents, temperatures, and SOCs of a plurality of parallel cell blocks to the ECU periodically (for example, every 10 seconds or every 1 minute) via an onboard network, whereby the ECU samples battery data on a time-series basis. For example, a controller area network (CAN) or a local interconnect network (LIN) can be used as the onboard network.

Communication unit 26 has the function of executing communication signal processing with communication unit 33 of charge stand 30 and the function of executing radio signal processing for connection to network 5. For example, communication unit 26 can use a mobile phone network (a cellular network), wireless LAN, Vehicle to Infrastructure (V2I), Vehicle to Vehicle (V2V), an electronic toll collection system (ETC system), or dedicated short range communications (DSRC) to access network 5.

Network 5 is a generic term for communication channels, such as the Internet, dedicated lines, and virtual private networks (VPN), and any communication medium and any protocol can be applied thereto. Examples of the communication medium that can be used include a mobile phone network, wireless LAN, cable LAN, an optical fiber network, an ADSL network, and a CATV network. Examples of the communication protocol that can be used include Transmission Control Protocol (TCP)/Internet Protocol (IP), User Datagram Protocol (UDP)/IP, or Ethernet (registered trademark) can be used as.

The ECU may send sampled battery data to battery analysis system 10 each time or may store the sampled battery data in an internal memory and simultaneously send the battery data stored in the memory to battery analysis system 10 at a predetermined timing. Note that, in a state in which electric vehicle 20 and charge stand 30 are connected by a charging cable, the ECU may send battery data stored in the memory to battery analysis system 10 via charge stand 30.

By connecting electric vehicle 20 to charge stand 30 with a charging cable, battery assembly system 21 in electric vehicle 20 can be charged from the outside. Charge stand 30 is connected to commercial power system 2 and charges battery assembly system 21.

In general, AC charge is applied for normal charge, meanwhile DC charge is applied for quick charge. When AC charge (for example, single-phase 100/200 V) is applied, a charge voltage or a charge current is controlled by a charger (not illustrated) in electric vehicle 20. When DC charge is applied, a charge voltage or a charge current is controlled by power supply unit 31 of charge stand 30. Power supply unit 31 includes a rectifier circuit, a filter, and a DC/DC converter. AC power supplied from commercial power system 2 is rectified through full-wave rectification by the rectifier circuit and smoothed with the filter to generate DC power. The DC/DC converter controls the voltage or current of the generated DC power.

As quick charge standards, for example, CHAdeMO (registered trademark), ChaoJi, GB/T, and a combined charging system (Combo) can be used. In CHAdeMO, ChaoJi, and GB/T, CAN is used as a communication protocol. In Combo, power line communication (PLC) is used as a communication protocol.

A charging cable for which the CAN protocol is used includes a communication line as well as a power line. When electric vehicle 20 and charge stand 30 are connected by the charging cable, control unit 25 of electric vehicle 20 establishes a communication channel with control unit 32 of charge stand 30. Note that, in a charging cable for which the PLC protocol is used, a communication signal is superimposed on the power line and transmitted.

Communication unit 33 of charge stand 30 has the function of executing communication signal processing to communicate with communication unit 26 of electric vehicle 20 and the function of executing signal processing to connect to network 5. Communication unit 33 can access network 5 by using, for example, a wired LAN, a wireless LAN, or a cellular network.

Battery analysis system 10 includes control unit 11, memory unit 12, and communication unit 13. Communication unit 13 is a communication interface (for example, network interface card (NIC)) for connecting to network 5 by wired or wireless means.

Control unit 11 includes acquisition unit 111, first preprocessing unit 112, determination unit 113, second preprocessing unit 114, analysis unit 115, and notification unit 120. The function of control unit 11 can be realized by a combination of hardware and software resources or by a hardware resource alone. Examples of the hardware resource that can be used include CPU, ROM, RAM, a graphics processing unit (GPU), an application specific integrated circuit (ASIC), a field programmable gate array (FPGA), and other LSIs. Examples of the software resource that can be used include programs such as operating systems and applications. Control unit 11 is realized, for example, by a computer including a central processing unit (CPU) and memory. When the CPU executes a program stored in the memory, the computer functions as control unit 11. The program is prerecorded in the memory of control unit 11 in the present specification, but may be provided through a telecommunication line such as the Internet or may be recorded on a (non-transient) recording medium such as a memory card and provided.

Memory unit 12 includes a non-volatile recording medium such as HDD or SSD and stores various types of data. Memory unit 12 includes battery data retention unit 121. Acquisition unit 111 is configured to acquire battery data from electric vehicle 20 or charge stand 30 and accumulate the acquired battery data in battery data retention unit 121.

Analysis unit 115 reads time-series data of a battery pack that are retained in battery data retention unit 121 and analyzes the battery pack. In the present embodiment, analysis items for the battery pack include a cell fault analysis to detect whether or not the battery pack includes a faulty cell.

The faulty cell is a malfunctioned cell and is caused due to the opening of a gas discharge valve, the activation of a current interrupt device (CID), wire breakage, the contact failure of a terminal, lithium deposition, or the like. The opening of the gas discharge valve and the activation of the CID are triggered when an internal pressure of a battery rises abnormally. The opening of the gas discharge valve, the activation of CID, the wire breakage, and the lithium deposition are irreversible faults, while the contact failure of the terminal is a reversible fault. In the present embodiment, the cell fault also includes significant capacity degradation due to lithium deposition and other factors. When a faulty cell is left to stand as it is, current loads on the rest of cells in a parallel cell block including the faulty cell increase, whereby the rest of the cells are easily induced to become faulty.

In cell fault detection, analysis unit 115 detects whether or not a cell fault has occurred in a target block, based on a voltage change in a normal parallel cell block (hereinafter, simply referred to as "normal block") and a voltage difference between the normal block and a target parallel cell block (hereinafter, simply referred to as "a target block").

An object of the analysis item is to nondestructively detect a block including a faulty cell (hereinafter, referred to as "a faulty block"). Notification unit 120 sends a result detected by analysis unit 115 to communication unit 26 of electric vehicle 20 via network 5 by using communication unit 13, and control unit 25 of electric vehicle 20 displays, on display unit 28, an indication of the detected result received by communication unit 26. Thus, the user can be notified of the occurrence of the cell fault, so that the replacement or repair of the battery pack can be urged and thereby the occurrence of an unstable event can be prevented. Hereinafter, a specific description will be given.

In the present embodiment, an index called a voltage fault level is used to detect a faulty block. The voltage fault level is a unique index configured to utilize the fact that, when the same amount of current [Ah] is charged or discharged, a lower state of health (SOH) of a battery causes a larger amount of change in OCV and SOC, and the voltage fault level can be used to detect an abnormality in the capacity of the block.

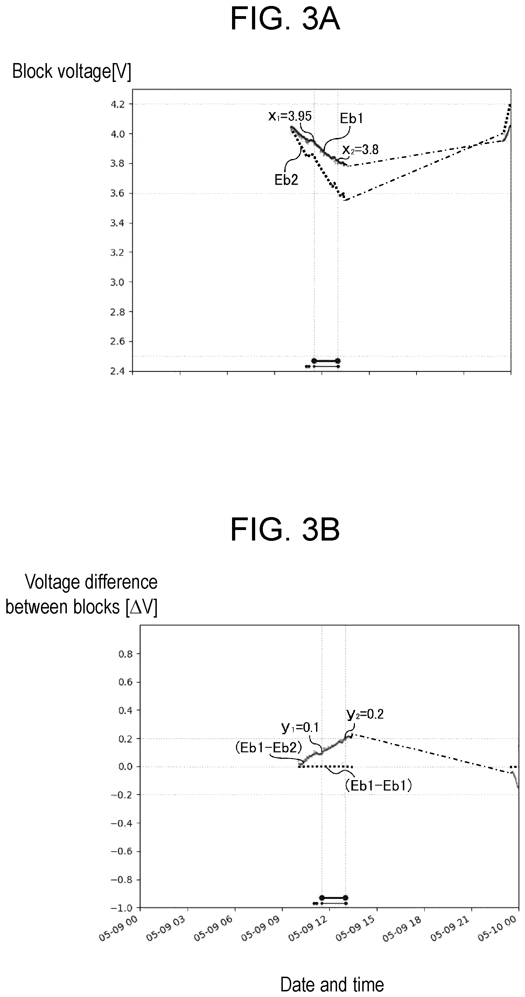

FIG. 3A is a diagram illustrating an example of changes in the voltage of a block. FIG. 3B is a diagram illustrating an example of changes in the voltage difference between blocks. In FIG. 3A, the horizontal axis indicates date and time, the vertical axis indicates block voltage [V], and changes in the voltage of first block Eb1 and changes in the voltage of second block Eb2 are illustrated. In FIG. 3B, the horizontal axis indicates date and time, and the vertical axis indicates the voltage difference [ΔV] between blocks, and changes in the voltage difference [ΔV] between first block Eb1 and second block Eb2 and changes in the voltage difference [ΔV] between first block Eb1 and first block Eb1.

In FIG. 3A and FIG. 3B, a state observed when discharge is continuously performed on May 9 from approximately 11:30 for approximately two hours. As illustrated in FIG. 3A, both the voltage of first block Eb1 and the voltage of second block Eb2 decrease. Second block (faulty block) Eb2 including a faulty cell exhibits a behavior of a battery with a substantially greatly lower SOH, and therefore the voltage of second block Eb2 decreases more rapidly than the voltage of the first block Eb1 (normal block).

As illustrated in FIG. 3B, the voltage difference between first block Eb1 (normal block) and second block Eb2 (faulty block) increases. An index that quantifies the speed of the increase in the voltage difference is the voltage fault level.

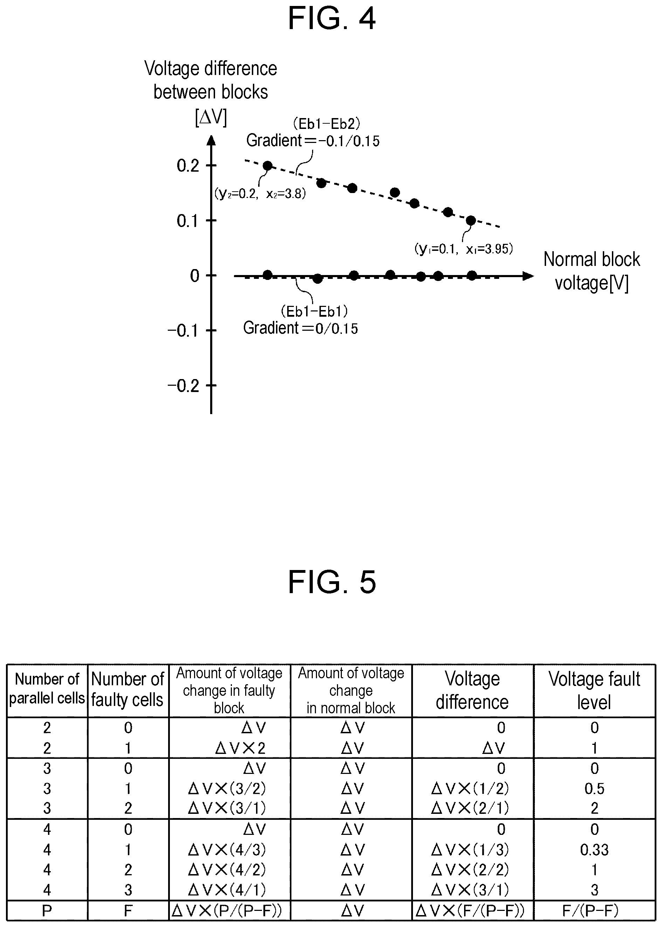

FIG. 4 is a graph illustrating a relationship between the voltage of the normal block illustrated in FIG. 3A and the voltage difference between the blocks illustrated in FIG. 3B. In FIG. 4, the voltage difference between first block Eb1 and second block Eb2 and the voltage difference between first block Eb1 and first block Eb1 in a range of 3.8 V to 3.95 V of the normal block voltage are plotted. In addition, approximate lines obtained by linear regression of the voltage difference plots by using the least squares method are illustrated.

Each of the approximate lines has a gradient that is approximately proportional to the SOH difference between blocks. The gradient of a linear regression line of the voltage difference between first block Eb1 and second block Eb2 is (-0.1/0.15). The gradient of a linear regression line of the difference in voltage between first block Eb1 and first block Eb1 is (0/0.15).

In the present embodiment, a value obtained by normalizing the rate of increase in the voltage difference between the blocks by using a change in the voltage of the normal block is defined as the voltage fault level of a target block. When a value of the voltage fault level is larger, a larger voltage difference between the blocks is generated with a smaller amount of charge/discharge. Among the voltage defect levels of target blocks, the largest absolute value thereof is defined as the voltage fault level of the battery pack. In other words, the voltage fault level of the battery pack is the voltage fault level of a block whose SOH is most different from that of the normal block. In the example illustrated in FIG. 4, the voltage fault level of the battery pack is 0.67 (= 0.1/0.15). A large value of the voltage fault level indicates the presence of a block whose SOH is greatly different from that of the normal block and indicates a high possibility of the presence of a faulty cell.

Next, a threshold to be compared to the voltage fault level will be described. A state in which a predetermined number or more of cells among parallel cells included in a block are faulty (completely malfunctioned) is desirably determined as abnormal, but the above-described voltage fault level is an index of the SOH difference between blocks, and therefore, even when there are variations in SOH, some value is derived. Therefore, an appropriate threshold for the voltage fault level needs to be set to distinguish between a fault and an acceptable SOH variation.

FIG. 5 is a diagram summarizing setting rules for a threshold to be compared with the voltage fault level. In this example, assuming that an SOC-OCV curve has a proportional relationship, a threshold is set. In other words, it is assumed that, when the amount of change in SOC doubles, the amount of change in OCV also doubles. In the present embodiment, the voltage fault level is defined as (Amount of change in voltage of faulty block - Amount of change in voltage of normal block) / Amount of change in voltage of normal block.

Hereinafter, the number of parallel cells in a block is referred to as P and the number of faulty cells in the block is referred to as F. When F pieces of cells out of P pieces of parallel cells are faulty, current loads equivalent to those of P cells are applied to the remaining normal (P - F) pieces of cells. When the amount of change in the voltage of a normal block having been subjected to charge or discharge is $\Delta V$, the amount of change in the voltage of a faulty block is $\Delta V \times (P/(P - F))$. At this time, the difference in voltage between the normal block and the faulty block is $\Delta V - (\Delta V \times (P/(P - F))) = \Delta V \times (F/(P - F))$. The voltage fault level is $\Delta V \times (F/(P - F))/\Delta V = F/(P - F)$.

For example, when the number of parallel cells in a block is four (P = 4) and one of the four parallel cells is faulty (F = 1), the voltage fault level is 1/(4 - 1) = 0.333. When two of the four parallel cells are faulty (F = 2), the voltage fault level is 2/(4 - 2) = 1. Note that the voltage fault level is a numerical value determined only by the ratio of the number of parallel cells in a block to the number of faulty cells in the block. For example, both when one of four parallel cells is faulty and when ten of fourty parallel cells are faulty, the voltage fault level is 0.333.

The voltage fault level is an index of the increment of current loads on each of the remaining normal cells at the time of the occurrence of a faulty cell, in which current loads on each cell is defined as 1 when there is no cell fault in a block. For example, a voltage fault level = 0.333 indicates that the occurrence of a cell fault in a block causes a 1.333 ( 1 + 0.333) times increase in the current loads on each of the remaining normal cells.

The designer may set a threshold to 0.333 when a state in which 1/4 or more of parallel cells in a block become faulty is detected as abnormal. The designer may set the threshold to 0.5 when a state in which 1/3 or more of parallel cells in a block become faulty is detected as abnormal. The designer may set the threshold to 1 when a state in which 1/2 or more of parallel cells in a block become faulty is detected as abnormal. Thus, the designer can adjust the sensitivity of fault detection as desired.

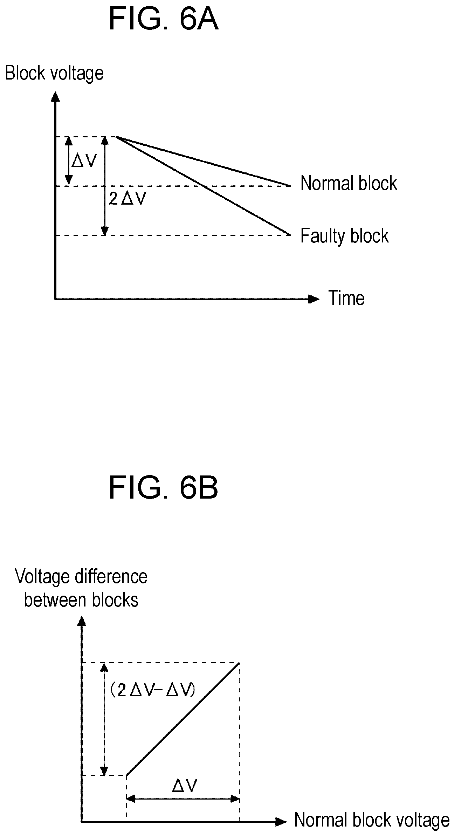

FIG. 6A and FIG. 3B are graphs illustrating that, when the number of parallel cells P in a block is 2 and the number of faulty cells F in the block is 1, the voltage fault level is 1. In FIG. 6A, changes in the voltage of a faulty block and changes in the voltage of a normal block are illustrated. In FIG. 6B, the relationship between the voltage of the normal block and the voltage difference between the faulty block and the normal block.

When the number of parallel cells P is 2 and the number of faulty cells F is 1, the SOH of a faulty block can be regarded as 1/2 of the SOH of a normal block, and hence the amount of change in the voltage of the faulty block is twice ($2\Delta V$) as much as the amount of change in the voltage $\Delta V$ of the normal block. Consequently, the voltage fault level is ($2\Delta V - \Delta V$)/$\Delta V$ = 1.

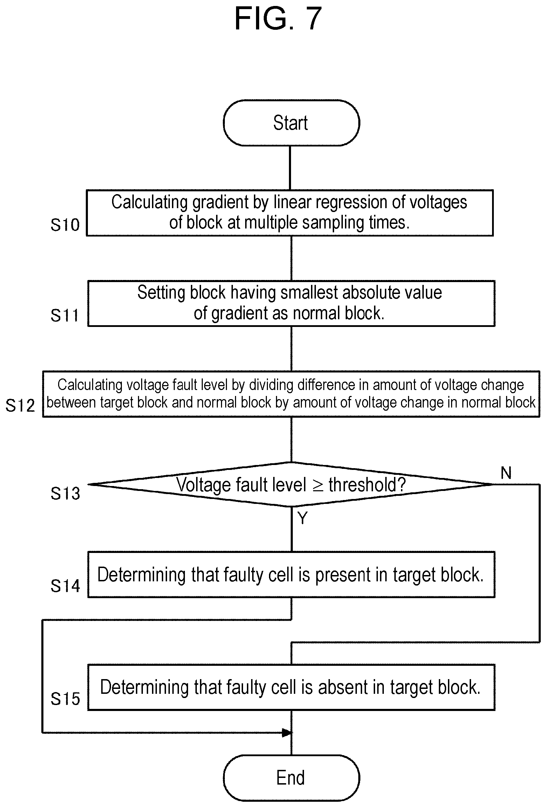

FIG. 7 is a flowchart illustrating the flow of basic processing for cell fault detection. Analysis unit 115 calculates the gradient of a linear regression line of voltage change in each block by linear regression of voltage data of each block at a plurality of sampling times (S10). Analysis unit 115 sets, as a normal block, a block having the smallest absolute value of the calculated gradient of the linear regression line of voltage change in each block (S11). Analysis unit 115 calculates the voltage fault level of a target block by dividing (normalizing) the difference in the amount of voltage change between the target block and the normal block by the amount of voltage change in the normal block (S12).

In other words, when the amount of voltage change in the normal block is $\Delta V$ and the amount of voltage change in the target block is $\Delta Vn$, analysis unit 115 calculates $|(\Delta Vn - \Delta V)|/\Delta V$ and thereby calculates the voltage fault level of the target block.

When the voltage fault level is equal to or more than a threshold (Y at S13), analysis unit 115 determines that the target block includes a faulty cell (S14). When the voltage fault level is below the threshold (N at S13), analysis unit 115 determines that the target block does not include a faulty cell (S15).

Return to FIG. 1. Data analysis basically needs continuous data, and therefore the imputation of data in a missing section are commonly applied as preprocessing. In many cases, data imputation causes an increase in the number of matched samples and leads to increased analysis opportunities and enhanced analysis precision.

First preprocessing unit 112 can read the time-series data of the battery pack, the time-series data being retained in battery data retention unit 121, and apply preprocessing to the time-series data. First preprocessing unit 112 identifies a missing section, based on time stamps of records of the time-series data. First preprocessing unit 112 imputes an estimated value in the missing section.

First preprocessing unit 112 can use a common imputation method to impute a value in the missing section. For example, first preprocessing unit 112 imputes the same value as that of a section just before the missing section, as a value in the missing section (numerical value holding). For example, first preprocessing unit 112 imputes, as a value in the missing section, a value obtained by estimation by linear interpolation based on values of sections just before and after the missing section (linear interpolation). For example, when values in a section just before or after the missing section change with a linear gradient, first preprocessing unit 112 imputes, as a value in the missing section, a value estimated by linear extrapolation based on the linear gradient (linear extrapolation). Note that a polynomial imputation method such as spline imputation may also be used.

First preprocessing unit 112 produces a file including an ID (for example, flag) sequence that indicates whether record values of time-series data are actual measured values or imputed values. First preprocessing unit 112 stores the time-series data obtained after imputation processing in battery data retention unit 121.

Note that imputation processing for the missing section is sometimes performed by control unit 25 of electric vehicle 20. Alternatively, the imputation processing may be performed by an external system other than battery analysis system 10. In these cases, acquisition unit 111 acquires time-series data including an imputed value.

In the execution of data analysis, determination unit 113 determines whether each of the values included in the time-series data of the battery pack read from battery data retention unit 121 is an actual measured value or an imputed value. When the above-mentioned ID is present, determination unit 113 refers to the ID to determine whether each of the values is an actual measured value or an imputed value. When the above-mentioned ID is absent, determination unit 113 detects a change pattern of the values in the time-series data and determines whether each of the values is an actual measured value or an imputed value.

For example, determination unit 113 determines that the same values included in the time series data and continuously distributed in a section are imputed values. There are fluctuations in actual measured values detected by the sensor, and hence, numbers of digits to the right of the decimal point are usually unequal. When exactly the same values are continuously distributed, it can be determined that these values are highly likely to have been imputed by an imputation program.

For example, determination unit 113 determines that values included in the time-series data and linearly changing in a section are imputed values. There are fluctuations in actual measured values detected by the sensor, and hence, even when a phenomenon of linear change of voltage or current occurs, usually, the values do not change at a perfectly linear gradient. It can be determined that a section in which values change linearly at exactly the same gradient is highly likely to be a section having been subjected to imputation by an imputation program.

When whether or not the time-series data include an imputed value cannot be determined by ID, determination unit 113 basically needs to scan changing patterns of values included in the time-series data. However, processing loads increase when value-changing patterns of all sections of the time-series data are scanned.

Therefore, when a value included in the time-series data satisfies a predetermined condition (for example, the start of current application), determination unit 113 may execute determination processing (that is, scanning for changing patterns) to determine whether a value included in the time-series data is an actual measured value or an imputed value in a section including the value. For other sections, the scanning of changing patterns is not performed, so that processing loads can be reduced.

When the time-series data to be analyzed include an imputed value, second preprocessing unit 114 can switch between using or not using the imputed value for data analysis. As described above, data imputation in a faulty section basically leads to increased analysis opportunities and improved analysis precision. In contrast, the presence of an imputed value very rarely causes a decrease in analysis precision. In such special case, second preprocessing unit 114 deletes the imputed value from the time-series data so as not to use the imputed value in data analysis.

To ensure the precision of cell fault detection described above, it is important to ensure the precision of a primary regression line of the voltage difference between blocks, and it is necessary to ensure the precision of voltage data serving as the basis. Hereinafter, a method of improving the precision of voltage fault level calculation by filtering voltage data to be used will be described.

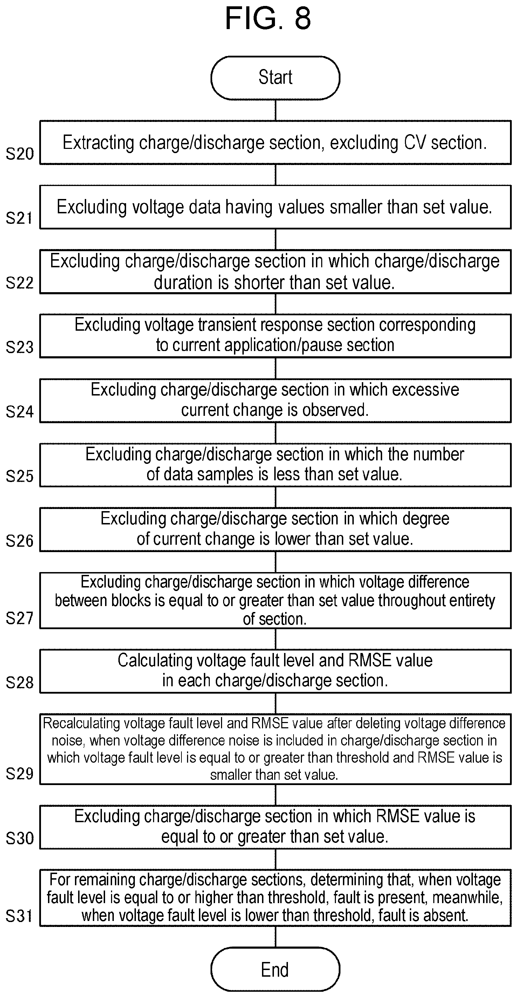

FIG. 8 is a flowchart for explaining a specific example of filtering in faulty cell detection processing performed by battery analysis system 10 according to the embodiment. In this specific example, time-series data of the battery pack that include an imputed value having been preprocessed by first preprocessing unit 112 or control unit 25 of electric vehicle 20 are targeted for analysis.

Analysis unit 115 extracts a charge/discharge section, excluding a constant voltage (CV) section (S20), from the time-series data of the battery pack. From the extracted charge/discharge section, analysis unit 115 excludes voltage data having values smaller than a set value (S21). For example, for a battery pack to which a lithium nickel manganese cobalt oxide (NMC) cathode material is used, voltage values less than 3.4 V are excluded. For a battery pack to which a lithium cobalt oxide (LCO) cathode material is used, voltage values less than 3.8 V are excluded.

Analysis unit 115 excludes voltage data in which the duration of charge/discharge is less than a set value (for example, 10 minutes) (S22). Analysis unit 115 excludes voltage data in a voltage transient response section corresponding to a current application/pause section (S23). A specific example of the voltage transient response section will be described later.

Analysis unit 115 excludes voltage data in a charge/discharge section with excessive current fluctuations (S24). For example, analysis unit 115 excludes voltage data in a charge/discharge section in which the ratio of the maximum current to the minimum current in the charge/discharge section is equal to or greater than a set value.

Analysis unit 115 excludes voltage data in a charge/discharge section in which the number of data samples is less than a set value (S25). Analysis unit 115 excludes voltage data in a charge/discharge section in which the degree of current change is less than a set value (S26). More specifically, analysis unit 115 excludes voltage data in a charge/discharge section in which the voltage change width of a parallel cell block exhibiting the smallest voltage change, out of parallel cell blocks included in a battery pack, is less than a set value.

Analysis unit 115 excludes voltage data in a charge/discharge section in which the voltage difference between blocks is equal to or greater than a set value throughout the entirety of the section (S27). More specifically, analysis unit 115 excludes voltage data in a charge/discharge section in which the difference between the maximum voltage and the minimum voltage of a plurality of parallel cell blocks included in a battery pack is equal to or greater than a set value throughout the entirety of the section.

Analysis unit 115 calculates voltage fault levels and root mean square error (RMSE) values in the remaining charge/discharge sections (S28). As described above, one of the voltage fault levels of a plurality of parallel cell blocks in a battery pack, the one having the largest absolute value, is defined as the voltage fault level. The largest one of the RMSE values of primary regression lines of the voltage difference between blocks in the battery pack is defined as the RMSE value.

When a voltage difference noise is included in a charge/discharge section in which the voltage fault level is equal to or greater than a threshold and the RMSE value is smaller than a set value, analysis unit 115 recalculates the voltage fault level and the RMSE value after removing the voltage difference noise (S29). The voltage difference noise is a voltage difference being such that the difference between a voltage of a target block and a voltage of the best block having the highest SOH is equal to or greater than a set value, the difference between the voltage of the target block and the previous voltage is less than the set value, and the difference between the voltage of the target block and the next voltage is less than the set value. When a voltage difference noise is not detected, it is not necessary to recalculate the voltage fault level and the RMSE value.

Analysis unit 115 excludes voltage data in a charge/discharge section in which the RMSE value is equal to or greater than a set value (S30). For the remaining charge/discharge sections, analysis unit 115 determines that, when the voltage fault level is equal to or higher than a threshold, a fault is present, and determines that, when the voltage fault level is lower than the threshold, no fault is present (S31). Set values used in filtering processings in the flowchart illustrated in FIG. 8 are set by the designer, based on the results of experiments and simulations. Hereinafter, a transient response filter at step S23 will be described in detail.

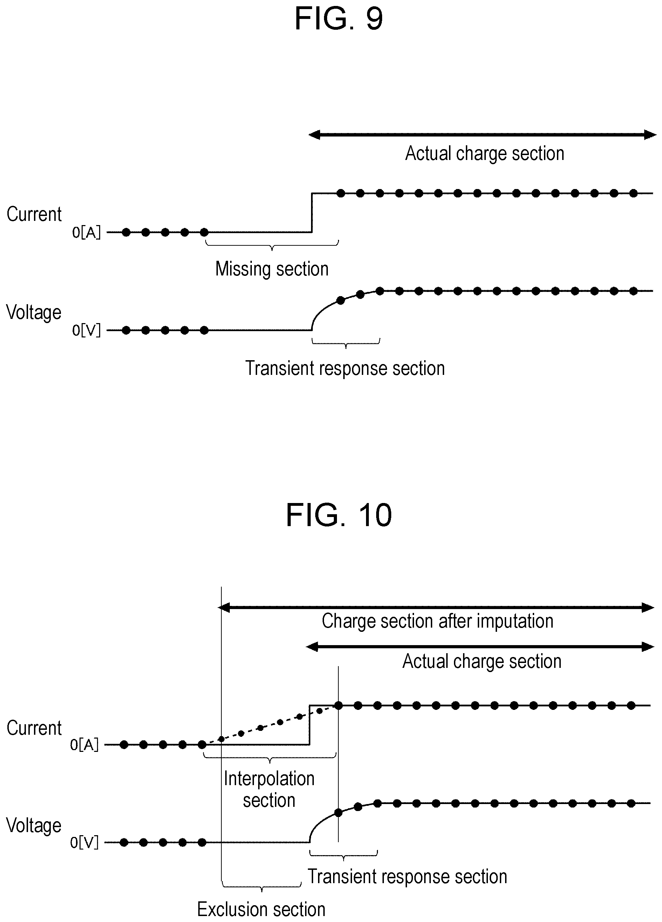

FIG. 9 is a diagram for explaining the role of the transient response filter. In FIG. 9, a change in current waveform and a change in voltage waveform at the time of switching from a pause section to a charge section. Waveforms expressed by solid lines represent an actual current waveform and an actual voltage waveform, respectively. Black dots represent actual measured current values measured by current sensor 23 and actual measured voltage values measured by voltage sensor 22.

Besides ohmic resistance components, a secondary battery includes non-ohmic resistance components, such as reaction resistance components and diffusion resistance components. Therefore, after current is applied to the secondary battery, the voltage of the secondary battery changes with a time constant. Voltage data in a transient response section in which voltage does not change linearly with current are desirably excluded because there is the risk of inducing the misjudgment of cell fault detection.

To exclude the voltage data in the transient response section, it is conceivable to exclude voltage data included in a range from a first current sample point in a charge section to a sample point located a predetermined period ahead of the first current sample point. For example, when the predetermined period is set to 5 minutes and a sampling rate is set to 1 minute, voltage data at 5 points ahead of the first current sample point of the charge section are targeted to be excluded.

Data missing often occurs between a pause section and a charge section. During the pause section, a microcontroller often pauses and hence cannot sample data.

FIG. 10 is a diagram illustrating time-series data of current in which a missing section illustrated in FIG. 9 is imputed by interpolation. First preprocessing unit 112 or control unit 25 of electric vehicle 20 connects current data before the missing section to current data after the missing section by using a straight line (indicated by a dotted line in FIG. 10) and plots imputed values (indicated by smaller black dots in FIG. 10) on the straight line at a predetermined sampling rate.

Analysis unit 115 recognizes a first sample point at which current data changes from 0 to a positive value, as a start point in a charge section. Analysis unit 115 excludes a predetermined number of samples (for example, five samples) of voltage data, plotted ahead of the start point of the charge section. In the example illustrated in FIG. 10, voltage data in an actual transient response section thereof are not excluded. When an interpolation section is longer than an exclusion section, the voltage data in the transient response section cannot be excluded. Also when the interpolation section is shorter than the exclusion section, voltage data behind the transient response section cannot be excluded.

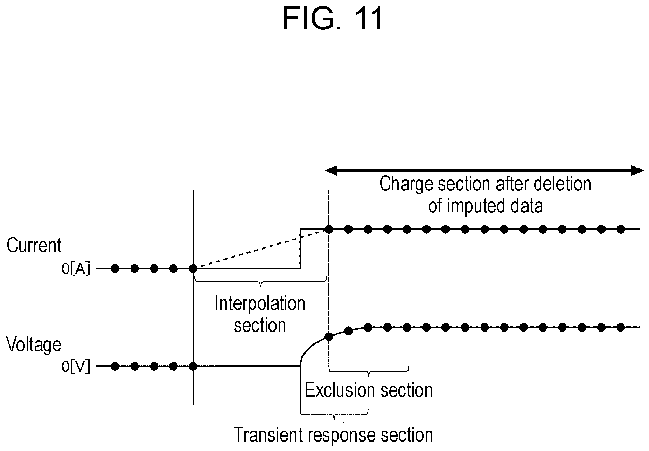

FIG. 11 is a diagram illustrating time-series data of current from which imputed data illustrated in FIG. 10 are deleted. Second preprocessing unit 114 deletes current data in an interpolation section. Thus, analysis unit 115 recognizes not the first imputed data in which current data change from 0 to a positive value, but the first actual measured data in which current data change to a positive value, as a start point of a charge section. Thus, the location of an exclusion section can be prevented from deviating significantly from the location of the transient response section. Analysis unit 115 excludes a predetermined number of samples of voltage data from the start point of the charge section. In the example illustrated in FIG. 11, the use of voltage data in the transient response section is avoided.

Thus, the voltage of secondary batteries rises with a delay relative to the rise in current due to a resistance component caused by a chemical reaction. In a transient response region of a plurality of parallel cell blocks in a battery pack, variations in the voltages of the parallel cell blocks are likely to occur. For example, a very small difference in SOH, temperature, or current density between the parallel cell blocks causes a large difference in voltage. As illustrated in FIG. 11, by excluding voltage data in the transient response region and determining the presence or absence of a cell defect, based on voltage data in a stable region, the precision of cell defect detection can be improved.

Although FIG. 9 to FIG. 11 illustrate examples of deleting imputed data interpolated between the pause section and the charge section, the imputed data interpolated between the pause section and the discharge section can also be deleted in the same way. When a range for searching for the presence or absence of imputed data is narrowed down to reduce processing loads, determination unit 113 starts searching for the imputed data at the time when current data rises from 0 to a positive or negative value. The searching range is a range from a sample point of the positive or negative value to a sample point going back a predetermined period.

Note that analysis unit 115 recognizes the first sample point at which the current data changes from a positive or negative value to 0, as an end point of the charge or discharge section. Second preprocessing unit 114 deletes imputed data around the end point of the charge or discharge section. Analysis unit 115 excludes a predetermined number of samples of voltage data toward the past from the end point after the deletion of imputed data in the charge or discharge section.

Second preprocessing unit 114 can switch between deleting or not deleting imputed values included in the time-series data, depending on the contents of data analysis. As described above, in the cell fault detection, the deletion of imputed values leads to the improvement of detection precision. In contrast, in an SOH diagnosis, imputed values are desirably used as they are without deleting the imputed values.

SOH is calculated based on the following (Formula 1) and (Formula 2).

$$FCC = \Sigma I/DOD \text{ ... (Formula 1)}$$

$$SOH = present\ FCC\ /\ initial\ FCC \text{ ... (Formula 2)}$$

Specifically, analysis unit 115 calculates a difference (depth of discharge: DOD) between SOC corresponding to OCV at the start of charge or discharge and SOC corresponding to OCV at the end of the charge or discharge, and calculates a current integrated value $\Sigma I$ for a charge or discharge period. Analysis unit 115 estimates a full charge capacity (FCC), based on a depth of discharge (DOD) and a current integrated value $\Sigma I$, as illustrated in (Formula 1) above. Analysis unit 115 estimates SOH, based on the estimated FCC and an initial FCC, as illustrated in (Formula 2) above. SOH is specified as the ratio of a current FCC to an initial FCC. A lower value (closer to 0%) of SOH indicates the progress of deterioration.

To calculate SOH as illustrated in (Formula 1) above, a current integrated value $\Sigma I$ needs to be calculated, and current data missing greatly decreases the precision of calculation of the current integrated value $\Sigma I$. Therefore, imputed values of current data are desirably used. Voltage data are beneficially available at two points, that is, at the start and the end of charge or discharge. Voltage data in other periods are unnecessary, and the precision of the voltage data in the other periods does not affect the precision of SOH calculation.

Besides cell fault detection and SOH diagnosis, there are various types of analysis items for battery packs, such as internal resistance estimation and micro-short-circuit detection. Based on a calculation algorithm for each of the analysis items, whether or not to use an imputed value for analysis is pre-set in second preprocessing unit 114.

Two types of time-series data may be prepared, that is, time-series data of a battery pack that include an imputed value imputed by first preprocessing unit 112 or control unit 25 of electric vehicle 20 and time-series data of the battery pack that do not include an imputed value. When the time-series data of the battery pack that include the imputed value imputed by control unit 25 of electric vehicle 20 is sent to battery analysis system 10, first preprocessing unit 112 deletes the imputed value from the time-series data to generate time-series data not including an imputed value. Depending on the contents of data analysis, analysis unit 115 properly uses time-series data including an imputed value or uses time-series data not including an imputed value.

In the flowchart illustrated in FIG. 8, cell fault detection is performed after the deletion of imputed values included in the transient response section. Here, analysis unit 115 may perform the cell fault detection by analyzing time-series data from which imputed values have not been deleted. When an abnormality is detected in the result of the analysis, second preprocessing unit 114 deletes the imputed values from the time-series data of the battery pack. Analysis unit 115 reanalyzes the time-series data from which the imputed values have been deleted. There are basically few cases in which an abnormality is detected in the cell fault analysis, and therefore, only when an abnormality is detected, imputed values may be deleted. By reanalyzing the time-series data from which imputed values have been deleted, the certainty of a result obtained by analyzing time-series data from which imputed values have not been deleted can be confirmed.

As described above, according to the present embodiment, by switching between using or not using imputed values included in time-series data in accordance with the contents of analysis, a data set corresponding to the contents of the analysis can be prepared and thereby the precision of the analysis can be improved. Compared to a case in which the quality of imputed values is judged to determine whether or not to use the imputed values, processing loads can be reduced. In the present embodiment, the condition for using or not using imputed values is clear, and whether or not to use imputed values can be easily determined. Note that display unit 28 configured to display the occurrence of a cell fault detected is not necessarily provided in electric vehicle 20, and the occurrence of the cell fault detected may be displayed on analysis system 10 including a display unit or on a display of a device connected to battery analysis system 10 via network 5.

Hereinbefore, the present disclosure has been described, based on the embodiment. Those skilled in the art will understand that the embodiment is merely an example and various modifications can be made to a combination of the constituents and a combination of the processing processes and such modifications are also included within the scope of the present disclosure.

Used for battery analysis system 10 according to the present disclosure is not limited to the analysis of a battery pack installed in electric vehicle 20. For example, battery analysis system 10 can be also used for the analysis of a battery pack installed in an electric motor ship, a multicopter (drone), an electric motorbike, an electric-assisted bicycle, a stationary energy storage system, a smart phone, a tablet, a notebook PC, or the like.

A method of switching between using or not using imputed values included in time-series data in accordance with the contents of analysis according to the present disclosure is also applicable to other types of data, besides time-series data of a battery pack. For example, in video data captured by a camera, an imputed frame is sometimes inserted between frames actually captured to smooth the video. For example, video data with a frame rate of 120 Hz or 240 Hz are sometimes produced from video data with a frame rate of 60 Hz. For purely evaluating the optical hardware performance of a camera (for example, the performance of a CMOS image sensor) from captured video data, analysis is performed after the deletion of imputed frames. Thus, the risk of misdiagnosis of the optical hardware performance of a camera a frame image added by software processing is reduced.

Note that the embodiment may be specified by the following items.

[Item 1]

A data analysis system (10), including:

an analysis unit (115) configured to analyze time-series data;
a determination unit (113) configured to determine whether each of values included in the time-series data is an actual measured value or an imputed value; and
a preprocessing unit (114) capable of switching between using and not using an imputed value for data analysis when the time-series data includes the imputed value.

Thus, the precision of data analysis can be improved.

[Item 2]

The data analysis system (10) according to Item 1, wherein the preprocessing unit (114) deletes the imputed value from the time-series data.

Thus, adverse effects arising from an imputed value on data analysis can be prevented.

[Item 3]

The data analysis system (10) according to Item 1 or 2, wherein, when identification information indicating whether each of the values included in the time-series data is an actual measured value or an imputed value is present, the determination unit (113) determines whether each of the values is an actual measured value or an imputed value, with reference to the identification information.

Thus, an imputed value can be easily and precisely identified.

[Item 4]

The data analysis system (10) according to Item 1 or 2, wherein the determination unit (113) detects change patterns of values included in the time-series data to determine whether each of the values is an actual measured value or an imputed value.

Thus, even when identification information indicating an imputed value is not provided, an imputed value can be found from the time-series data.

[Item 5]

The data analysis system (10) according to Item 4, wherein the determination unit (113) determines that values included in the time-series data and continuously distributed in a section or values included in the time-series data and linearly changing in a section are determined as imputed values.

Thus, an imputed value inserted by numerical hold or linear imputation can be found.

[Item 6]

The data analysis system (10) according to Item 4, wherein, when a value included in the time-series data satisfies a predetermined condition, the determination unit (113) executes processing to determine whether each of values in a section surrounding the value is an actual measured value or an imputed value.
Thus, processing loads can be reduced.

[Item 7]

The data analysis system (10) according to Item 1, wherein the preprocessing unit (114) switches between deleting and not deleting the imputed value in accordance with the contents of data analysis.
Thus, imputed values can be easily and clearly treated.

[Item 8]

The data analysis system (10) according to Item 1, wherein

the analysis unit (115) analyzes time-series data from which an imputed value is not deleted, and,
when an abnormality is detected in an analysis result, the preprocessing unit (114) deletes the imputed value from the time-series data, and
after the imputed value is deleted, the analysis unit (115) reanalyzes the time-series data.

Thus, the frequency of processing to delete an imputed value can be reduced.

[Item 9]

The data analysis system (10) according to Item 1, wherein

time-series data including an imputed value and time-series data not including the imputed value are prepared, and, depending on the contents of data analysis, the analysis unit (115) selectively uses the time-series data including the imputed value or the time-series data not including the imputed value.

Thus, depending on the contents of data analysis, the most appropriate time-series data can be used.

[Item 10]

The data analysis system (10) according to Item 1, wherein the time-series data are battery data including at least voltage of a secondary battery (21).
Thus, the precision of analysis of a secondary battery can be improved.

[Item 11]

The data analysis system (10) according to Item 1, further including

an acquisition unit (111) configured to acquire voltage data of a plurality of parallel cell blocks of a battery pack (21), the parallel cell blocks being connected in series, each of the parallel cell blocks including a plurality of cells connected in parallel,
wherein, based on a voltage change in a normal parallel cell block and a change in voltage difference between the normal parallel cell block and a target parallel cell block, the analysis unit (115) detects whether or not a cell fault occurs in the target parallel cell block.

Thus, a cell fault in a parallel cell block can be easily detected in a non-destructive manner.

[Item 12]

A data analysis system (10) according to Item 11, wherein
the analysis unit (115)

calculates a voltage fault level by calculating | (ΔVn - ΔV) | /ΔV, the ΔV representing a voltage change in the normal parallel cell block, the ΔVn representing a voltage change in the target parallel cell block, and determines that a cell fault occurs in the target parallel cell block, when the voltage fault level is equal to or higher than a threshold.

Thus, based on a quantified index, whether or not a cell fault in a parallel cell block is present can be determined.

[Item 13]

A data analysis method, including:

determining whether each of values included in time-series data is an actual measured value or an imputed value;
switching between using or not using an imputed value for data analysis when the time-series data includes the imputed value; and
analyzing the time-series data.

Thus, the precision of data analysis can be improved.

[Item 14]

A data analysis program configured to cause a computer to execute:

processing to determine whether each of values included in time-series data is an actual measured value or an imputed value;
processing to switch between using or not using an imputed value for data analysis when the time-series data includes the imputed value; and
processing to analyze the time-series data.

Thus, the precision of data analysis can be improved.

**REFERENCE MARKS IN THE DRAWINGS**

1...cell defect notification system
2...commercial power system
5...network
10...battery analysis system
11... control unit
12...memory unit
13...communication unit
20...electric vehicle
21...battery assembly system
22...voltage sensor
23...current sensor
24...temperature sensor
25...control unit
26...communication unit
30...charge stand
31...power supply unit
32...control unit
33...communication unit
111...acquisition unit
112...first preprocessing unit
113...determination unit
114...second preprocessing unit
115...analysis unit
121...battery data retention unit

**Claims**

1. A data analysis system, comprising:

   an analysis unit configured to analyze time-series data;
   a determination unit configured to determine whether each of values included in the time-series data is an actual measured value or an imputed value; and
   a preprocessing unit capable of switching between using and not using an imputed value for data analysis when the time-series data includes the imputed value.

2. The data analysis system according to Claim 1, wherein the preprocessing unit deletes the imputed value from the time-series data.

3. The data analysis system according to Claim 1 or 2, wherein, when identification information indicating whether each of the values included in the time-series data is an actual measured value or an imputed value is present, the determination unit determines whether each of the values is an actual measured value or an imputed value, with reference to the identification information.

4. The data analysis system according to Claim 1 or 2, wherein the determination unit detects change patterns of values included in the time-series data to determine whether each of the values is an actual measured value or an imputed value.

5. The data analysis system according to Claim 4, wherein the determination unit determines that the values included in the time-series data which are identically and continuously distributed in a section or the values included in the time-series data which are linearly changing in a section are determined as imputed values.

6. The data analysis system according to Claim 4, wherein, when the values included in the time-series data satisfy a predetermined condition, the determination unit executes processing to determine whether each of values in a section surrounding the values is an actual measured value or an imputed value.

7. The data analysis system according to Claim 1, wherein the preprocessing unit switches between deleting and not deleting the imputed value in accordance with contents of the data analysis.

8. The data analysis system according to Claim 1, wherein

   the analysis unit analyzes time-series data from which an imputed value is not deleted, and,
   when an abnormality is detected in an analysis result, the preprocessing unit deletes the imputed value from the time-series data, and,
   after the imputed value is deleted, the analysis unit reanalyzes the time-series data.

9. The data analysis system according to Claim 1, wherein

   time-series data including an imputed value and time-series data not including the imputed value are prepared, and,
   depending on contents of the data analysis, the analysis unit selectively uses the time-series data including the imputed value or the time-series data not including the imputed value.

10. The data analysis system according to Claim 1, wherein the time-series data are battery data including at least voltage of a secondary battery.

11. The data analysis system according to Claim 1, further comprising

    an acquisition unit configured to acquire voltage data of a plurality of parallel cell blocks of a battery pack, the parallel cell blocks being connected in series, each of the parallel cell blocks including a plurality of cells connected in parallel,
    wherein, based on a voltage change in a normal parallel cell block and a change in voltage difference between the normal parallel cell block and a target parallel cell block, the analysis unit detects whether or not a cell fault occurs in the target parallel cell block.

12. The data analysis system according to Claim 11, wherein
the analysis unit

calculates a voltage fault level by calculating $|(\Delta Vn - \Delta V)|/\Delta V$, the $\Delta V$ representing a voltage change in the normal parallel cell block, the $\Delta Vn$ representing a voltage change in the target parallel cell block, and
determines that a cell fault occurs in the target parallel cell block, when the voltage fault level is equal to or higher than a threshold.

13. The data analysis system according to Claim 11, further comprising
a notification unit configured to send an occurrence of the cell fault detected by the analysis unit.

14. The data analysis system according to Claim 13, further comprising
a display unit configured to display the occurrence of the cell fault notified by the notification unit.

15. A cell defect notification system, comprising
a display unit including the data analysis system according to Claim 13 and configured to display the occurrence of the cell fault notified by the notification unit.

16. A data analysis method, comprising:

determining whether each of values included in time-series data is an actual measured value or an imputed value;
switching between using or not using an imputed value for data analysis when the time-series data includes the imputed value; and
analyzing the time-series data.

17. A data analysis program configured to cause a computer to executing:

processing to determine whether each of values included in time-series data is an actual measured value or an imputed value;
processing to switch between using or not using an imputed value for data analysis when the time-series data includes the imputed value; and
processing to analyze the time-series data.

18. A non-transitory storage medium on which the data analysis program according to Claim 17 is written.

19. The data analysis method according to Claim 16, further comprising:

acquiring voltage data of a plurality of parallel cell blocks of a battery pack, the parallel cell blocks being connected in series, each of the parallel cell blocks including a plurality of cells connected in parallel;
based on a voltage change in a normal parallel cell block and a change in voltage difference between the normal parallel cell block and a target parallel cell block, detecting whether or not a cell fault occurs in the target parallel cell block;
sending an occurrence of the cell fault detected by the analysis unit; and
displaying the occurrence of the cell fault.

# FIG. 1

Electric vehicle (20)

- 28 Display unit
- 25 Control unit
- 22 Voltage sensor
- 23 Current sensor
- 24 Temperature sensor
- 21 Battery assembly system
- 26 Communication unit

Charge stand (30)

- 31 Power supply unit
- 32 Control unit
- 33 Communication unit
- 2
- 1

- 5

Battery analysis system (10)

- 13 Communication unit

Memory unit (12)
- 121 Battery data retention unit

Control unit (11)
- 111 Acquisition unit
- 112 First preprocessing unit
- 113 Determination unit
- 114 Second preprocessing unit
- 115 Analysis unit
- 120 Notification unit

# FIG. 2

# FIG. 3A

Block voltage[V]

# FIG. 3B

Voltage difference
between blocks [ΔV]

Date and time

# FIG. 4

Voltage difference between blocks [ΔV]

(Eb1−Eb2) Gradient=−0.1/0.15

(y₂=0.2, x₂=3.8)

(y₁=0.1, x₁=3.95)

Normal block voltage[V]

(Eb1−Eb1) Gradient=0/0.15

# FIG. 5

| Number of parallel cells | Number of faulty cells | Amount of voltage change in faulty block | Amount of voltage change in normal block | Voltage difference | Voltage fault level |
|---|---|---|---|---|---|
| 2 | 0 | ΔV | ΔV | 0 | 0 |
| 2 | 1 | ΔV×2 | ΔV | ΔV | 1 |
| 3 | 0 | ΔV | ΔV | 0 | 0 |
| 3 | 1 | ΔV×(3/2) | ΔV | ΔV×(1/2) | 0.5 |
| 3 | 2 | ΔV×(3/1) | ΔV | ΔV×(2/1) | 2 |
| 4 | 0 | ΔV | ΔV | 0 | 0 |
| 4 | 1 | ΔV×(4/3) | ΔV | ΔV×(1/3) | 0.33 |
| 4 | 2 | ΔV×(4/2) | ΔV | ΔV×(2/2) | 1 |
| 4 | 3 | ΔV×(4/1) | ΔV | ΔV×(3/1) | 3 |
| P | F | ΔV×(P/(P−F)) | ΔV | ΔV×(F/(P−F)) | F/(P−F) |

# FIG. 6A

Block voltage

ΔV

2ΔV

Normal block

Faulty block

Time

# FIG. 6B

Voltage difference
between blocks

(2ΔV−ΔV)

ΔV

Normal block voltage

# FIG. 7

```
                    ┌─────────────┐
                    │    Start    │
                    └─────────────┘
                           │
       ┌───────────────────────────────────────────────┐
  S10  │ Calculating gradient by linear regression of voltages │
       │       of block at multiple sampling times.       │
       └───────────────────────────────────────────────┘
                           │
       ┌───────────────────────────────────────────────┐
  S11  │     Setting block having smallest absolute value │
       │          of gradient as normal block.           │
       └───────────────────────────────────────────────┘
                           │
       ┌───────────────────────────────────────────────────────────────────┐
  S12  │ Calculating voltage fault level by dividing difference in amount of voltage change │
       │ between target block and normal block by amount of voltage change in normal block │
       └───────────────────────────────────────────────────────────────────┘
                           │
                    ◇─────────────────────◇    N
  S13          Voltage fault level ≥ threshold?
                    ◇─────────────────────◇
                           │ Y
       ┌───────────────────────────────────────────────┐
  S14  │ Determining that faulty cell is present in target block. │
       └───────────────────────────────────────────────┘
                           │
       ┌───────────────────────────────────────────────┐
  S15  │ Determining that faulty cell is absent in target block. │
       └───────────────────────────────────────────────┘
                           │
                    ┌─────────────┐
                    │     End     │
                    └─────────────┘
```

# FIG. 8

Start

S20 — Extracting charge/discharge section, excluding CV section.

S21 — Excluding voltage data having values smaller than set value.

S22 — Excluding charge/discharge section in which charge/discharge duration is shorter than set value.

S23 — Excluding voltage transient response section corresponding to current application/pause section

S24 — Excluding charge/discharge section in which excessive current change is observed.

S25 — Excluding charge/discharge section in which the number of data samples is less than set value.

S26 — Excluding charge/discharge section in which degree of current change is lower than set value.

S27 — Excluding charge/discharge section in which voltage difference between blocks is equal to or greater than set value throughout entirety of section.

S28 — Calculating voltage fault level and RMSE value in each charge/discharge section.

S29 — Recalculating voltage fault level and RMSE value after deleting voltage difference noise, when voltage difference noise is included in charge/discharge section in which voltage fault level is equal to or greater than threshold and RMSE value is smaller than set value.

S30 — Excluding charge/discharge section in which RMSE value is equal to or greater than set value.

S31 — For remaining charge/discharge sections, determining that, when voltage fault level is equal to or higher than threshold, fault is present, meanwhile, when voltage fault level is lower than threshold, fault is absent.

End

# FIG. 9

# FIG. 10

# FIG. 11

## INTERNATIONAL SEARCH REPORT

| | International application No. |
|---|---|
| | **PCT/JP2023/044925** |

**A. CLASSIFICATION OF SUBJECT MATTER**

***G01R 31/396***(2019.01)i; ***G01R 31/367***(2019.01)i; ***H02J 7/00***(2006.01)i
FI:   G01R31/396; H02J7/00 Q; G01R31/367

According to International Patent Classification (IPC) or to both national classification and IPC

**B. FIELDS SEARCHED**

Minimum documentation searched (classification system followed by classification symbols)

G01R31/36; H02J7/00; G01R31/00; G06F3/00; G06F11/00; H04L27/12; H04L27/20; H04N7/01

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 9-204742 A (SANYO ELECTRIC CO., LTD.) 05 August 1997 (1997-08-05) paragraphs [0001], [0009], [0015]-[0031], fig. 1-7 | 1-3, 7, 16-18 |
| A | | 4-6, 8-15, 19 |
| A | JP 2019-175544 A (SUMITOMO ELECTRIC IND., LTD.) 10 October 2019 (2019-10-10) entire text, all drawings | 1-19 |
| A | JP 2018-98143 A (MITSUBISHI JIDOSHA KOGYO KABUSHIKI KAISHA) 21 June 2018 (2018-06-21) entire text, all drawings | 1-19 |
| A | JP 2022-89753 A (KABUSHIKI KAISHA TOSHIBA) 16 June 2022 (2022-06-16) entire text, all drawings | 1-19 |
| A | JP 63-131675 A (SONY CORPORATION) 03 June 1988 (1988-06-03) entire text, all drawings | 1-19 |

☑ Further documents are listed in the continuation of Box C. ☑ See patent family annex.

\* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **01 February 2024** | **05 March 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

**INTERNATIONAL SEARCH REPORT**

| International application No. |
|---|
| **PCT/JP2023/044925** |

**C.    DOCUMENTS CONSIDERED TO BE RELEVANT**

| Category* | Citation of document, with indication, where appropriate, of the relevant passages | Relevant to claim No. |
|---|---|---|
| A | JP 2010-238094 A (SONY CORPORATION) 21 October 2010 (2010-10-21)<br>entire text, all drawings | 1-19 |
| A | JP 2017-143911 A (NIPPON TELEGR. & TELEPH. CORP.) 24 August 2017 (2017-08-24)<br>entire text, all drawings | 1-19 |
| A | JP 2005-158020 A (HITACHI, LTD.) 16 June 2005 (2005-06-16)<br>entire text, all drawings | 1-19 |

Form PCT/ISA/210 (second sheet) (July 2022)

## INTERNATIONAL SEARCH REPORT
### Information on patent family members

International application No.

**PCT/JP2023/044925**

| Patent document cited in search report | | | Publication date (day/month/year) | Patent family member(s) | Publication date (day/month/year) |
|---|---|---|---|---|---|
| JP | 9-204742 | A | 05 August 1997 | (Family: none) | |
| JP | 2019-175544 | A | 10 October 2019 | (Family: none) | |
| JP | 2018-98143 | A | 21 June 2018 | (Family: none) | |
| JP | 2022-89753 | A | 16 June 2022 | (Family: none) | |
| JP | 63-131675 | A | 03 June 1988 | (Family: none) | |
| JP | 2010-238094 | A | 21 October 2010 | US 2010/0245295 A1 entire text, all drawings CN 101853108 A | |
| JP | 2017-143911 | A | 24 August 2017 | (Family: none) | |
| JP | 2005-158020 | A | 16 June 2005 | US 2005/0096797 A1 entire text, all drawings | |

Form PCT/ISA/210 (patent family annex) (July 2022)

**REFERENCES CITED IN THE DESCRIPTION**

**Patent documents cited in the description**

- JP 2010238094 A